Europäisches Patentamt

European Patent Office

Office européen des brevets

(19)

(11) EP 1 120 657 A1

(12) DEMANDE DE BREVET EUROPEEN

(43) Date de publication:
01.08.2001 Bulletin 2001/31

(51) Int Cl.7: G01R 1/073

(21) Numéro de dépôt: 00403419.5

(22) Date de dépôt: 06.12.2000

(84) Etats contractants désignés:
AT BE CH CY DE DK ES FI FR GB GR IE IT LI LU
MC NL PT SE TR
Etats d'extension désignés:
AL LT LV MK RO SI

(30) Priorité: 13.12.1999 FR 9915679

(71) Demandeur: Upsys Probe Technology
91100 Corbeil Essonnes (FR)

(72) Inventeurs:
• Jurine, Jean Michel
F-91750 Nainville (FR)
• George, Isabelle
F-75011 Paris (FR)

(74) Mandataire: Breese, Pierre
Breese - Majerowicz - Simonnot
3, avenue de l'Opéra
75001 Paris (FR)

(54) **Connecteur de test de haute densité d'interconnexion pour circuits intégrés**

(57) La présente invention concerne un connecteur de test de haute densité d'interconnexion destiné notamment à la vérification de circuits intégrés, comportant une platine supportant une pluralité de broches conductrices dont l'une des extrémités forme une zone de contact avec le circuit électronique à tester et l'autre extrémité forme une zone de contact avec une platine de liaison avec un moyen de raccordement avec l'équipement de test, les broches conductrices présentant une forme apte à assurer une flexibilité comprenant une composante longitudinale, caractérisé en ce que les broches présentent une succession d'au moins trois sections arquées (4, 5, 6) dans des directions alternées prolongées de part et d'autre par des segments rectilignes mobiles selon un degré de liberté en translation axiale, les broches étant insérées dans des platines frontales.

FIG.1

EP 1 120 657 A1

**EP 1 120 657 A1**

## Description

La présente invention concerne le domaine des équipements de test de circuits intégrés à haute densité.

On connaît dans l'état de la technique des connecteurs permettant d'appliquer un grand nombre de pointes sur la surface du circuit intégré à vérifier. De tels connecteurs présentent un réseau dense de broches dont l'extrémité de contact est mobile pour permettre une adaptation aux défauts de planéité des circuits à vérifier, et aux défauts des équipements de manipulation. Ces broches sont reliées électriquement à un faisceau de câble permettant le raccordement à un équipement de contrôle.

A titre d'exemple, on connaît le brevet européen EP68270 décrivant un ensemble de test électrique comportant une pluralité d'éléments de test allongés constitués en matériau conducteur et flexible et des éléments de support supérieur et inférieur espacés ayant des orifices à travers lesquels passent les extrémités desdits éléments de test. L'élément de support inférieur maintient ces éléments de test suivant une disposition généralement parallèle, dans une configuration correspondant à celle des plots à contacter.

On connaît encore le brevet européen EP735372 décrivant un assemblage de broches traversant une platine perforée et comportant des éléments ressorts pour exercer une pression sur la surface de contact. Le brevet européen EP528608 décrit un connecteur pour tester un ensemble de circuit intégré, qui est monté en surface sur une carte de circuit imprimé et présente une configuration sensiblement rectangulaire incluant une surface supérieure, une surface inférieure, et quatre bords latéraux. Une série de conducteurs électriques s'étend à partir de l'un au moins desdits bords latéraux. Le connecteur comprend

- un boîtier de connecteur qui comporte un évidement sensiblement rectangulaire apte à s'ajuster au-dessus de l'ensemble de circuit intégré ;
- au moins un peigne en matière isolante pourvu d'une série de dents s'étendant latéralement vers l'intérieur dans ledit évidement à partir dudit boîtier de connecteur avec un espacement prédéfini entre chaque paire de dents adjacentes, lesdites dents étant aptes à être insérées de façon amovible entre lesdits conducteurs lorsque ledit boîtier de connecteur est ajusté au-dessus dudit ensemble de circuit intégré;
- un assemblage de cadre de conducteurs attaché audit boîtier de connecteur à l'intérieur dudit évidement ;
- un câble flexible qui inclut une série de conducteurs s'étendant en parallèle à partir dudit boîtier de connecteur vers un deuxième connecteur apte à réaliser les connexions électriques avec un équipement externe de test; et
- une série de broches conductrices montées dans lesdits orifices pourvus d'un revêtement de ladite couche isolante aptes à réaliser des interconnexions.

Le problème posé par les connecteurs de l'art antérieur est celui de la densité des broches et de la miniaturisation des contacts. Cette densité est limitée par les déformations de la broche lors de l'application sur la surface du circuit intégré à vérifier, et par la nécessité d'éviter impérativement tout contact entre les broches adjacentes. Un deuxième problème est celui de la maîtrise de la fonction course - force. Le but recherché est de travailler dans la partie de la courbe déplacement/force correspondant à la saturation, afin de garantir une force d'appui quasiment constante quelque soit l'extension de l'extrémité de la broche. Cette caractéristique permet d'assurer une force d'appui identique pour toutes les broches, même lorsque la surface de contact présente des défauts de planéité.

L'invention vise à atteindre ce but par un connecteur de test de haute densité d'interconnexion destiné notamment à la vérification de circuits intégrés, comportant une platine supportant une pluralité de broches conductrices dont l'une des extrémités forme une zone de contact avec le circuit électronique à tester et l'autre extrémité forme une zone de contact avec une platine de liaison avec un moyen de raccordement avec l'équipement de test, les broches conductrices présentant une forme apte à assurer une flexibilité comprenant une composante longitudinale, caractérisé en ce que les broches présentent une succession d'au moins trois sections arquées dans des directions alternées prolongées de part et d'autre par des segments rectilignes mobiles selon un degré de liberté en translation axiale, les broches étant insérées dans des platines frontales.

Selon le mode de réalisation préféré, les broches présentent une succession de trois sections arquées.

Selon une variante, les segments arqués présentent des longueurs croissantes depuis la pointe vers la platine de raccordement.

Selon un mode de réalisation préféré, le premier segment arqué présente une longueur $L_1$, le deuxième segment présente une longueur d'environ $1,5 \, L_1$ et le troisième segment présente une longueur d'environ $2,1 \, L_1$.

Selon un mode de réalisation particulier, le premier segment arqué présente une longueur $L_1$ = 480 micromètres, le deuxième segment présente une longueur d'environ 700 micromètres et le troisième segment présente une longueur d'environ 1000 micromètres.

De préférence, le premier segment arqué présente une forme définie par la fonction

2

$$y_1(x) = b_1 \cdot \left( 1 - \frac{2}{1 + e^{\left[ \frac{\left(\frac{L_1}{2}\right)^2 - x^2}{a_1^2} \right]}} \right)$$

avec

$b_1$ environ égal à 500
$a_1$ environ égal à 300
$L_1$ environ égal à 480 micromètres.

Avantageusement, le deuxième segment arqué présente une forme définie par la fonction

$$y_2(x) = b_2 \cdot \left( 1 - \frac{2}{1 + e^{\left[ \frac{\left(\frac{L_2}{2}\right)^2 - x^2}{a_2^2} \right]}} \right)$$

avec

$b_2$ environ égal à 300
$a_2$ environ égal à 300
$L_2$ environ égal à 700 micromètres.

De préférence, le troisième segment arqué présente une forme définie par la fonction

$$y_3(x) = b_3 \cdot x \cdot \left( \frac{1}{e^{a_3 x}} - \frac{1}{e^{a_3 L_3}} \right)$$

avec

$b_3$ environ égal à 1
$a_3$ environ égal à 0,005
$L_3$ environ égal à 1000 micromètres.

Selon un mode de réalisation particulier, le segment rectiligne est guidé sur une longueur d'environ 300 micromètres, et débute à une distance d'environ 100 micromètres du troisième segment arqué.
L'invention concerne également un procédé de fabrication d'une broche pour un connecteur caractérisé en ce que l'on prépare un substrat de type SOI formé par deux substrats en silicium fusionnés avec une couche d'interface d'oxyde de silicium, en ce que l'on usine selon un masque par gravure profonde sèche, en ce que l'on procède ensuite à la gravure de la couche d'oxyde de silicium, en ce que l'on procède à un dépôt métallique par pulvérisation cathodique et/ou dépôt chimique et en ce que l'on libère ensuite les éléments.
Selon une variante, la broche est réalisée par gravure chimique directe dans une plaque métallique de type tungstène, palladium, cuivre ou équivalent.
L'invention concerne encore un équipement de test de circuits intégrés caractérisé en ce qu'il comporte un connecteur conforme à l'invention.
L'invention sera mieux comprise à la lecture de la description qui suit, se référant à un exemple non limitatif de réalisation et aux figures annexées où :

- la figure 1 représente une vue de face d'une broche selon l'invention ;
- la figure 2 représente une vue de profil de la broche selon l'invention ;
- la figure 3 représente une vue agrandie de l'extrémité de contact de la broche ;
- les figures 4 à 6 représentent des vues en coupe de la broche selon les plans de coupe AA, BB, et CC.

La broche selon l'invention présente une extrémité de contact (1) prévue à l'extrémité d'un segment rectiligne (2) dont l'axe médian est confondu avec l'axe médian du segment rectiligne (3) formant l'extrémité opposée de la broche.

La broche présente entre ces deux segments rectilignes :

- un premier segment arqué (4) ;
- un second segment arqué (5) ;
- un troisième segment arqué (6).

Le premier segment présente au repos un ventre. Il rejoint le second segment (5) par une pente de raccordement formant environ 45° avec l'axe longitudinal (7). Le raccordement avec le segment rectiligne (2) s'effectue avec une variation brusque de la pente. La tangente à l'extrémité du premier segment arqué (4) forme un angle d'environ 45° avec l'axe médian du segment rectiligne (2) .

Le deuxième segment arqué (5) forme également un ventre, en sens opposé par rapport au ventre du premier segment arqué. Le troisième segment présente un ventre d'une amplitude, dans le même sens que le premier ventre. La liaison avec le segment rectiligne (3) se fait par une zone doucement incurvée (8).

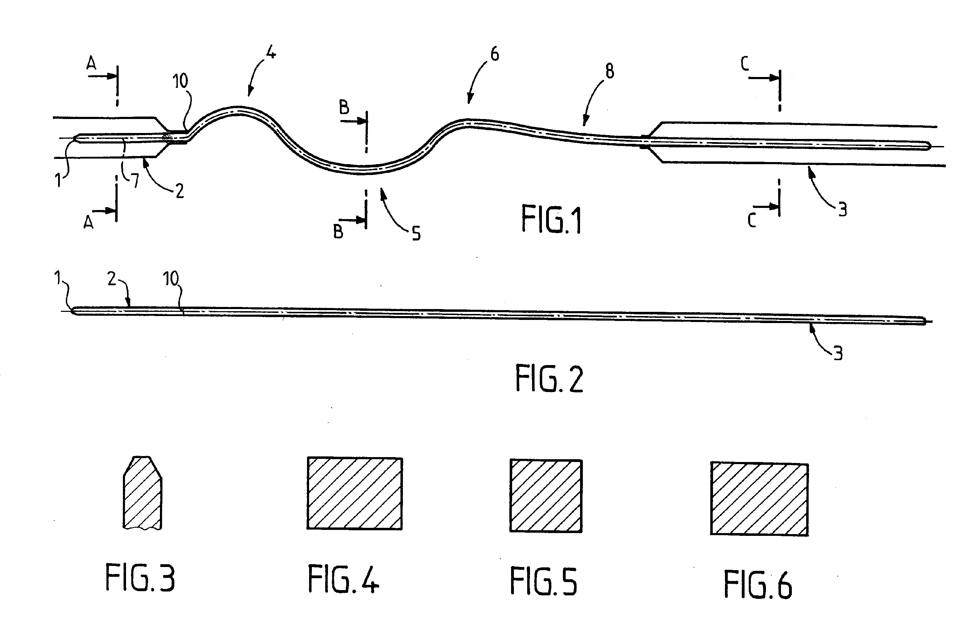

L'extrémité de contact (1) présente une forme trapézoïdale comme représenté en vue agrandie en figure 3. La pente des flancs est d'environ 60°. La partie frontale plane présente la forme d'un carré.

Le segment rectiligne (2) présente une section rectangulaire comme représenté en figure 4.

La partie arquée présente une section carrée comme représentée en figure 5, avec un coté d'environ.

La partie rectiligne (3) présente une section rectangulaire comme représenté en figure 6.

Le segment rectiligne avant (2) présente à proximité de la zone de raccordement avec le premier segment arqué (4) un épaulement (10) d'une épaisseur de l'ordre de 0,015 millimètres. Cette épaulement permet d'exercer une précontrainte sur la broche lorsqu'elle est introduite entre les deux platines perforée formant le connecteur.

Les broches ainsi réalisées sont insérées de façon connue entre deux platines présentant un réseau de perforations pour assurer le guidage des extrémités rectilignes (2, 3) à l'image des contacts du circuit intégré à vérifier. Eventuellement, seul le segment arrière (3) pourrait être guidé, le segment avant (2) étant libre. Le pas du réseau peut atteindre 50 micromètres avec les broches selon l'invention.

Elles peuvent être montées de façon précontraintes. Elles sont alors positionnées entre deux platines dont l'écartement est légèrement inférieur entre la distance entre les épaulements de la broche, afin d'exercer une contrainte axiale au repos sur les broches.

La fabrication des broches peut être réalisée par une technique de découpe d'un substrat de type SOI (Silicon on Insulator) formé par un support N ou P de type [100] dopé de façon à présenter une résistance la plus faible possible et une épaisseur de quelques dizaines de micromètres.

La couche d'oxyde de silicium présente une épaisseur de quelques micromètres. La base est de type N ou P de type [100] et présente une épaisseur de 350 à 500 micromètres.

On usine ce substrat selon un masque par gravure profonde du silicium en utilisant un plasma haute densité à couplage inductif ce qui permet d'atteindre des vitesses de gravure élevée, des sélectivités importantes et des gravures verticales indépendamment de l'orientation cristalline du substrat. Ce procédé permet de garantir une section carrée des broches.

On procède ensuite à une gravure de la couche d'oxyde à l'acide fluorhydrique, afin de libérer les broches du support. On procède ensuite à un dépôt métallique par pulvérisation cathodique ou PVD (plasma vapour deposition) ou CVD (chemical vapour deposition) avant de procéder à la découpe des broches pour séparer les éléments adjacents.

**Revendications**

1. Connecteur de test de haute densité d'interconnexion destiné notamment à la vérification de circuits intégrés, comportant une platine supportant une pluralité de broches conductrices dont l'une des extrémités forme une zone de contact avec le circuit électronique à tester et l'autre extrémité forme une zone de contact avec une platine de liaison avec un moyen de raccordement avec l'équipement de test, les broches conductrices présentant une forme apte à assurer une flexibilité comprenant une composante longitudinale, caractérisé en ce que les broches présentent une succession d'au moins trois sections arquées (4, 5, 6) dans des directions alternées prolongées de part et d'autre par des segments rectilignes mobiles selon un degré de liberté en translation axiale, les broches étant insérées dans des platines frontales.

2. Connecteur de test de haute densité d'interconnexion selon la revendication précédente caractérisé en ce que les broches présentent une succession de trois sections arquées.

3. Connecteur de test de haute densité d'interconnexion selon l'une quelconque des revendications précédentes caractérisé en ce que les segments arqués présentent une longueur croissante depuis la pointe vers la platine de raccordement.

4. Connecteur de test de haute densité d'interconnexion selon l'une quelconque des revendications précédentes caractérisé en ce que le premier segment arqué (4) présente une longueur $L_1$, le second segment arqué (5) présente une longueur d'environ $1{,}5\ L_1$ et le troisième segment présente une longueur d'environ $2{,}1\ L_1$.

5. Connecteur de test de haute densité d'interconnexion selon l'une quelconque des revendications précédentes caractérisé en ce que le premier segment arqué (4) présente une forme définie par la fonction

$$y_1(x) = b_1 \cdot \left( 1 - \frac{2}{1 + e^{\left( \frac{\left(\frac{L_1}{2}\right)^2 - x^2}{a_1^2} \right)}} \right)$$

6. Connecteur de test de haute densité d'interconnexion selon l'une quelconque des revendications précédentes caractérisé en ce que le second segment arqué (5) présente une forme définie par la fonction

$$y_2(x) = b_2 \cdot \left( 1 - \frac{2}{1 + e^{\left( \frac{\left(\frac{L_2}{2}\right)^2 - x^2}{a_2^2} \right)}} \right)$$

7. Connecteur de test de haute densité d'interconnexion selon l'une quelconque des revendications précédentes caractérisé en ce que le troisième segment arqué (6)e présente une forme définie par la fonction

$$y_3(x) = b_3 \cdot x \cdot \left( \frac{1}{e^{a_3 x}} - \frac{1}{e^{a_3 L_3}} \right)$$

8. Connecteur de test de haute densité d'interconnexion selon l'une quelconque des revendications précédentes caractérisé en ce que le segment rectiligne est guidé sur une longueur d'environ 300 micromètres, et débute à une distance d'environ 100 micromètres du troisième segment arqué (6).

9. Connecteur de test de haute densité d'interconnexion selon la revendication 1 caractérisé en ce que les broches sont précontraintes.

10. Procédé de fabrication d'une broche pour un connecteur conforme à l'une au moins des revendications précédentes caractérisé en ce que l'on prépare un substrat de type SOI, en ce que l'on usine selon un masque par gravure profonde sèche, en ce que l'on procède ensuite à la gravure de la couche d'oxyde, en ce que l'on procède à un dépôt métallique et en ce que l'on découpe ensuite les éléments.

11. Procédé de fabrication d'une broche pour un connecteur comportant des broches présentant une succession d'au moins trois sections arquées (4, 5, 6) dans des directions alternées prolongées de part et d'autre par des segments rectilignes mobiles selon un degré de liberté en translation axiale, les broches étant insérées dans des platines frontales caractérisé en ce que les broches sont gravées chimiquement dans une plaque métallique.

12. Equipement de test de circuits intégrés caractérisé en ce qu'il comporte un connecteur comportant des broches présentant une succession d'au moins trois sections arquées (4, 5, 6) dans des directions alternées prolongées de part et d'autre par des segments rectilignes mobiles selon un degré de liberté en translation axiale, les broches étant insérées dans des platines frontales.

FIG.1

FIG.2

FIG.3

FIG.4

FIG.5

FIG.6

**Office européen
des brevets**

## RAPPORT DE RECHERCHE EUROPEENNE

Numéro de la demande

EP 00 40 3419

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | WO 99 49329 A (SV PROBE) 30 septembre 1999 (1999-09-30) | 1,2,12 | G01R1/073 |
| A | * page 5, ligne 16 - ligne 36 * <br> * page 6, ligne 34 - page 7, ligne 23 * <br> * page 11, ligne 8 - ligne 30 * <br> * page 12, ligne 26 - page 13, ligne 18 * <br> * page 14, ligne 11 - ligne 34 * <br> * page 16, ligne 18 - ligne 32 * <br> * page 17, ligne 15 - ligne 29; figures 1A,1B,3,5A,6 * | 9 | |
| A | EP 0 740 160 A (NIHON DENSHIZAIRYO) 30 octobre 1996 (1996-10-30) <br> * colonne 3, ligne 26 - colonne 59 * <br> * colonne 4, ligne 10 - ligne 15 * <br> * colonne 4, ligne 38 - ligne 53; figures 1-3,5-7 * | 1,2,11, 12 | |
| X | US 4 964 808 A (RIECHELMANN) 23 octobre 1990 (1990-10-23) <br> * colonne 1, ligne 41 - ligne 54; figure 4 * | 11 | |
| | | | DOMAINES TECHNIQUES RECHERCHES (Int.Cl.7) |
| A | WO 97 43656 A (FORMFACTOR) 20 novembre 1997 (1997-11-20) <br> * page 27, ligne 13 - ligne 22 * <br> * page 27, ligne 30 - page 28, ligne 23; figures 1A,2,6A-6C * | 1,2,10, 12 | G01R |

Le présent rapport a été établi pour toutes les revendications

| Lieu de la recherche | Date d'achèvement de la recherche | Examinateur |
|---|---|---|
| LA HAYE | 1 juin 2001 | Iwansson, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**                    EP 00 40 3419

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-06-2001

| Document brevet cité au rapport de recherche | | Date de publication | Membre(s) de la famille de brevet(s) | | Date de publication |
|---|---|---|---|---|---|
| WO 9949329 | A | 30-09-1999 | US | 5952843 A | 14-09-1999 |
| | | | AU | 3115499 A | 18-10-1999 |
| EP 740160 | A | 30-10-1996 | AUCUN | | |
| US 4964808 | A | 23-10-1990 | US | 4836797 A | 06-06-1989 |
| | | | WO | 8804782 A | 30-06-1988 |
| WO 9743656 | A | 20-11-1997 | US | 6064213 A | 16-05-2000 |
| | | | US | 5994152 A | 30-11-1999 |
| | | | US | 6184053 B | 06-02-2001 |
| | | | AU | 3073797 A | 05-12-1997 |
| | | | AU | 3073997 A | 05-12-1997 |
| | | | AU | 3127797 A | 09-12-1997 |
| | | | AU | 3136697 A | 05-12-1997 |
| | | | AU | 6377796 A | 11-12-1996 |
| | | | CN | 1208368 A | 17-02-1999 |
| | | | CN | 1197514 A | 28-10-1998 |
| | | | CN | 1225724 A | 11-08-1999 |
| | | | EP | 0859686 A | 26-08-1998 |
| | | | EP | 0898712 A | 03-03-1999 |
| | | | EP | 0839321 A | 06-05-1998 |
| | | | EP | 0839322 A | 06-05-1998 |
| | | | EP | 0839323 A | 06-05-1998 |
| | | | JP | 3058919 B | 04-07-2000 |
| | | | JP | 10506238 T | 16-06-1998 |
| | | | JP | 11504725 T | 27-04-1999 |
| | | | KR | 252457 B | 15-04-2000 |
| | | | WO | 9637332 A | 28-11-1996 |
| | | | WO | 9744676 A | 27-11-1997 |
| | | | WO | 9743653 A | 20-11-1997 |
| | | | WO | 9743654 A | 20-11-1997 |
| | | | AU | 3603497 A | 02-02-1998 |
| | | | WO | 9801906 A | 15-01-1998 |
| | | | US | 6150186 A | 21-11-2000 |
| | | | AU | 7294298 A | 27-11-1998 |
| | | | JP | 2001502851 T | 27-02-2001 |
| | | | WO | 9850953 A | 12-11-1998 |
| | | | US | 6043563 A | 28-03-2000 |

EPO FORM P0460

Pour tout renseignement concernant cette annexe : voir Journal Officiel de l'Office européen des brevets, No.12/82